**Europäisches Patentamt**

**European Patent Office**

**Office européen des brevets**

(11) Veröffentlichungsnummer: **0 181 015**

**B1**

(12) **EUROPÄISCHE PATENTSCHRIFT**

(45) Veröffentlichungstag der Patentschrift:
06.12.89

(21) Anmeldenummer: 85201493.5

(22) Anmeldetag: 18.09.85

(51) Int. Cl.⁴: **G 01 N 24/08**

(54) Schnellverfahren und Anordnung zur Ermittlung einer Kernmagnetisierungsverteilung in einem Teil eines Körpers.

(30) Priorität: 28.09.84 NL 8402959

(43) Veröffentlichungstag der Anmeldung:
14.05.86 Patentblatt 86/20

(45) Bekanntmachung des Hinweises auf die Patenterteilung:
06.12.89 Patentblatt 89/49

(84) Benannte Vertragsstaaten:
BE DE FR GB

(56) Entgegenhaltungen:
EP-A-0 103 397
DE-A-3 331 396
GB-A-2 056 078
GB-A-2 091 884
US-A-4 319 190

(73) Patentinhaber: **N.V. Philips' Gloeilampenfabrieken,**
**Groenewoudseweg 1, NL- 5621 BA Eindhoven (NL)**

(72) Erfinder: **den Boef, Johannes Hendrik, c/o INT.**
**OCTROOIBUREAU B.V. Prof. Holstlaan 6, NL-**
**5656 AA Eindhoven (NL)**

(74) Vertreter: **Faessen, Louis Marie Hubertus,**
**INTERNATIONAAL OCTROOIBUREAU B.V. 6**
**Prof. Holstlaan, NL- 5656 AA Eindhoven (NL)**

## Beschreibung

Die Erfindung betrifft ein Verfahren zum Ermitteln einer Kernspinmagnetisierungsverteilung in einem Teil eines Körpers, bei dem ein stationäres homogenes Magnetfeld erzeugt wird, in dem sich der Teil des Körpers befindet, und

a) ein hochfrequenter elektromagnetischer Impuls zum Auslösen einer präzedierenden Bewegung der Magnetisierung der Kerne im Körper erzeugt wird, wobei sich ein Resonanzsignal ergibt,

b) wobei nach einer Vorbereitungszeit während einer oder mehrerer Messzeiten ein stationäres Gradientenmagnetfeld und ein alternierendes, periodisches Gradientenmagnetfeld erzeugt wird, wobei die Messzeit(en) in eine Anzahl von Abtastintervallen zum Durchführen einer Anzahl von Signalabtastungen des Resonanzsignals aufgeteilt ist (sind),

c) wobei jeweils nach einer Wartezeit die Schritte a) und b) einige Male wiederholt werden, wobei die Dauer der Vorbereitungszeit und/oder das Integral zumindest eines in der Vorbereitungszeit angelegten Gradientenmagnetfelds über die Vorbereitungszeit jeweils einen verschiedenen Wert hat, zum Erhalten einer Gruppe von Signalabtastungen, aus der nach einer Signaltransformation ein Bild einer Kernmagnetisierung bestimmt wird.

Die Erfindung bezieht sich weiter auf eine Anordnung zur Ermittlung einer Kernmagnetisierungsverteilung in einem Teil eines Körpers, wobei die Anordnung folgendes enthält:

a) Mittel zum Erzeugen eines stationären, homogenen Magnetfelds,

b) Mittel zum Erzeugen hochfrequenter elektromagnetischer Strahlung,

c) Mittel zum Erzeugen eines konstanten Gradientenmagnetfelds,

d) Mittel zum Erzeugen eines alternierenden periodischen Gradientenmagnetfelds,

e) Abtastmittel für die Durchführung von Signalabtastungen eines mit den unter a) und b) genannten Mitteln erzeugten Resonanzsignals bei mit den unter c) und d) erwähnten Mitteln erzeugten stationären Gradientenmagnetfeld und alternierenden Gradientenmagnetfeld,

f) Verarbeitungsmittel zum Verarbeiten der Signalabtastungen zu einer Kernmagnetisierungsverteilung und

g) Steuermittel zum Steuern zumindest der unter b) bis f) erwähnten Mittel zum Erzeugen, Konditionieren und Abtasten einer Anzahl von Resonanzsignalen und zum Verarbeiten der Signalabtastungen.

Ein derartiges Verfahren und eine derartige Anordnung sind aus der niederländischen Patentanmeldung 8 203 519 bekannt. Beim bekannten Verfahren wird in der Messzeit ein alternierendes Gradientenmagnetfeld erzeugt, das periodisch ist und eine Periode gleich dem Abtastintervall hat, und wird je Abtastintervall zumindest eine zusätzliche Signalabtastung durchgeführt.

Wie in der bereits erwähnten DE-OS 3 331 396.2 erläutert, wird mit der Verwendung des alternierenden Gradientenmagnetfelds und der Durchführung der zusätzlichen Signalabtastungen erreicht, dass zumindest zwei Reihen einer (zweidimensionalen) Bildfrequenzmatrix nach der Abtastung eines Resonanzsignals (FID- oder Spinechosignal) gefüllt sind. Hierdurch wird die Dauer einer Messzyklus auf die Hälfte (ein Drittel, ein Viertel) bei der Durchführung von ein (zwei, drei) zusätzlicher Signalabtastung(en) reduziert. Da die Dauer eines Resonanzsignals nur wenige zehn Millisekunden beträgt, ist für die Durchführung von 128 oder 256 Signalabtastungen (auf einer Zeile in der Bildfrequenzmatrix) ein Abtastintervall in der Grössenordnung von 100 µs erforderlich, was bedeutet, dass die Frequenz des zusätzlichen Gradientenmagnetfelds 10 kHz betragen muss. Diese verhältnismässig hohe Frequenz für das alternierende Gradientenmagnetfeld bedeutet eine Beschränkung der maximalen Anzahl von Zeilen der Bildfrequenzmatrix, die durch Abtasten eines einzigen Resonanzsignals gefüllt werden kann. Der Hochstabstand $\Delta k$ zwischen zwei Zeilen, die durch Abtastung eines Resonanzsignals gefüllt werden, beträgt

$$\Delta k = \int_0^{1/2\,tm} \gamma \cdot G(\tau) \cdot d\tau,$$

worin 1,5 tm die erste Halbperiodischen, alternierenden Gradientenmagnetfelds, $\gamma$ das gyromagnetische Verhältnis und $G(\tau)$ das alternierende Gradientenmagnetfeld ist. Der Hochstabstand $\Delta k$ bestimmt die Höchstanzahl von Zeilen in der Bildfrequenzmatrix, die nach der Abtastung eines Resonanzsignals gefüllt worden sind, und ist proportional der Amplitude des angelegten alternierenden Gradientenmagnetfelds. Die Amplitude des alternierenden Gradientenmagnetfelds kann nicht beliebig vergrössert werden, da die Änderungsgeschwindigkeit dG/dt des alternierenden Gradientenmagnetfelds innerhalb von durch die Gesundheit vorgegeben Grenzen bleiben soll. Diese Änderungsgeschwindigkeit dG/dt ist proportional dem Produkt der Amplitude und der Frequenz des alternierenden Gradientenmagnetfelds. Da die Frequenz (10 kHz) verhältnismässig hoch ist, ist eine maximal zulässige Amplitude schnell erreicht. Wurde die erforderliche Zeit zum Ansammeln aller Signalabtastungen auf ein Viertel verkürzt werden, müsste die Amplitude des alternierenden Feldes um den Faktor 4 vergrössert werden.

Der Erfindung liegt die Aufgabe zugrunde, ein Verfahren und ein Anordnung zu schaffen, mit dem bzw. der verhältnismässig schwache, hochfrequente alternierende Gradientenmagnetfelder benutzt werden, wobei die erforderliche Zeit zur Erzeugung eines Bildes mit einer Auflösung, die zumindest genau so hoch ist wie bei der Durchführung des Verfahrens und der Verwendung der

3

Anordnung nach dem oben beschriebenen Stand der Technik, zur Erzeugung dreidimensionaler Kernmagnetisierungsverteilungen wesentlich kürzer ist.

Diese Aufgabe wird mit einem Verfahren nach der Erfindung dadurch gelöst, dass in der Messzeit ein zweites periodisch alternierendes Gradientenmagnetfeld angelegt wird, dessen Gradientenrichtung senkrecht zur Gradientenrichtung des erstgenannten alternierenden Gradientenmagnetfelds verläuft. Beim erfindungsgemässen Verfahren werden die Signalabtastungen bei einem einzigen FID-Signal nicht nur entlang einer Bildfrequenzlinie oder in einer Bildfrequenzebene gemessen, sondern in einem dreidimensionalen Teil des Bildfrequenzraums, der jetzt durch den zusätzlichen Freiheitsgrad des zweiten alternierenden Gradientenmagnetfelds durchlaufen werden kann.

Eine bevorzugte Ausführungsform des erfindungsgemässen Verfahrens ist dadurch gekennzeichnet, dass die zwei periodisch alternierenden Gradientenmagnetfelder die gleiche Periode haben und um 90° in der Phase gegeneinander verschoben sind. Bei der bevorzugten Ausführungsform des Verfahrens wird der Bildfrequenzraum (oder der Bildfrequenzzeitraum, wenn ortsabhängige Spektroskopie betrieben wird) über einen spiralförmigen Weg durchlaufen. So können je Periode vier Signalabtastungen durchgeführt werden, die auf den vier Ecken eines Vierecks liegen, das von der projizierten Spirale umschrieben wird. Daher wird die Gesamtmessdauer um den Faktor 3 gekürzt, wobei jedoch zwei alternierende Gradientenfelder erforderlich sind, die ein resultierendes Gradientenfeld erzeugen, das um den Faktor $\sqrt{2}$ stärker ist als ein einziges Gradientenfeld beim Stand der Technik (mit gleicher Frequenz), mit dem nur eine Halbierung der Gesamtmessdauer erreicht wird.

Ein weiteres Verfahren nach der Erfindung zum Ermitteln einer Kernspinmagnetisierungsverteilung in einem Teil eines Körpers, bei dem ein stationäres homogenes Magnetfeld erzeugt wird, in dem sich der Teil des Körpers befindet, und

a) ein hochfrequenter elektromagnetischer Impuls zum Auslösen einer präzedierenden Bewegung der Magnetisierung der Kerne im Körper erzeugt wird, wobei sich ein Resonanzsignal ergibt,

b) wobei nach einer Vorbereitungszeit während einer Messzeit oder mehrerer Messzeiten ein alternierendes, periodisches Gradientenmagnetfeld erzeugt wird, wobei die Messzeit(en) in eine Anzahl von Abtastintervallen zum Durchführen einer Anzahl von Signalabtastungen des Resonanzsignals aufgeteilt ist (sind),

c) wonach jeweils nach einer Wartezeit die Schritte a) und b) einige Male wiederholt werden, wobei die das Integral zumindest eines in der Vorbereitungszeit angelegten Gradientenmagnetfeld über die Vorbereitungszeit jeweils eines verschiedenen Wert hat, zum Erhalten einer Gruppe von Signalabtastungen

4

aus der nach einer Signaltransformation ein Bild einer Kernmagnetisierung bestimmt wird, sieht vor dass in der Messzeit ein zweites periodisches alternierendes Gradientenmagnetfeld angelegt wird, dessen Gradientenrichtung senkrecht zur Gradientenrichtung des erstgenannten alternierenden Gradientenmagnetfelds verläuft.

Eine erfindungsgemässe Anordnung ist dadurch gekennzeichnet, dass die Anordnung Mittel zum Erzeugen von zwei alternierenden Gradientenmagnetfeldern enthält, deren Gradientenrichtungen senkrecht zueinander verlaufen. Eine bevorzugte Ausführungsform einer erfindungsgemässen Anordnung ist dadurch gekennzeichnet, dass die alternierenden Gradientenmagnetfelder die gleichen Perioden haben und in der Phase um 90° verschoben sind.

Ausführungsbeispiele der Erfindung werden nachstehend an Hand der Zeichnung näher erläutert. Es zeigen

Fig. 1 schematisch ein Spulensystem einer Anordnung zur Durchführung eines erfindungsgemässen Verfahrens,

Fig. 2 ein Blockschaltbild einer Anordnung zur Durchführung des erfindungsgemässen Verfahrens,

Fig. 3a und 3b einfache Ausführungsbeispiele und Verfahren nach der Erfindung,

Fig. 4a und 4b ein bevorzugtes Ausführungsbeispiel eines erfindungsgemässen Verfahrens,

Fig. 5a und 5b eine Erläuterung zum Verfahren nach Fig. 4a und 4b, und

Fig. 6 einen Teil einer Anordnung zur Durchführung des erfindungsgemässen Verfahrens.

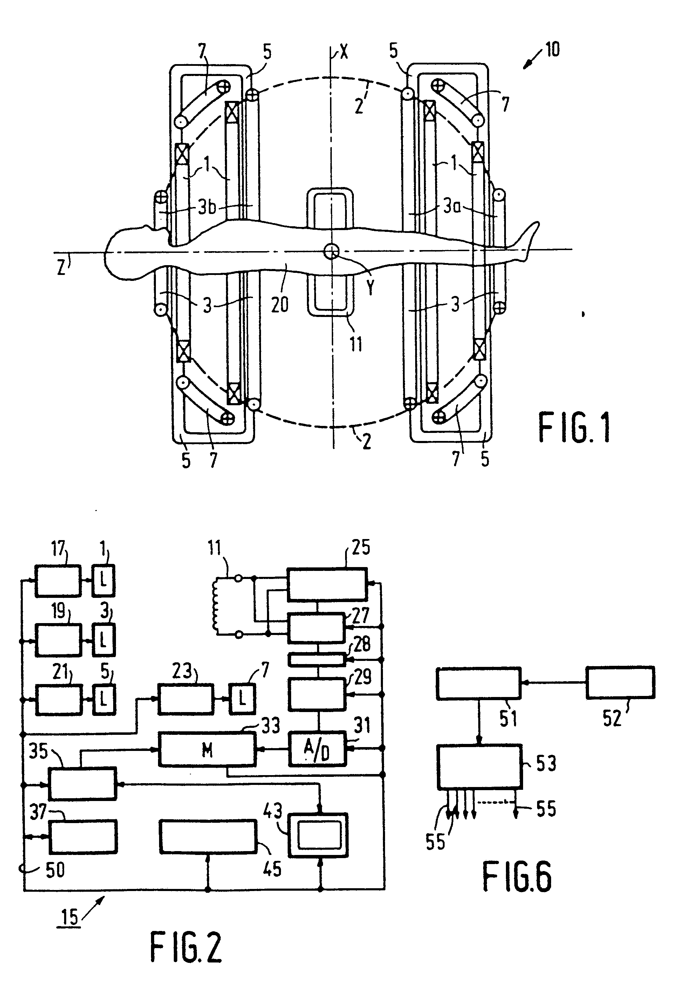

In Fig. 1 ist ein Spulensystem 10 dargestellt, das ein Teil einer Anordnung 15 ist (Fig. 2), die zur Ermittlung einer Kernmagnetisierungsverteilung in einem Teil eines Körpers 20 benutzt wird. Der Teil hat beispielsweise eine Dicke $\Delta z$ und liegt in der x-y-Ebene des dargestellten x-y-z-Koordinatensystem. Die y-Achse des Systems verläuft dabei senkrecht zur Zeichenebene nach oben. Mit dem Spulensystem 10 wird ein einheitliches stationäres Magnetfeld Bo mit einer Feldrichtung parallel zur z-Achse, drei Gradientenmagnetfelder $G_x$, $G_y$, $G_z$ mit einer Feldrichtung parallel zur z-Achse und mit einer Gradientenrichtung parallel zur x-, y- bzw. z-Achse und ein hochfrequentes Magnetfeld erzeugt. Dazu enthält das Spulensystem 10 einige Hauptspulen 1 zum Erzeugen des stationären homogenen Magnetfelds Bo. Die Hauptspulen 1 können beispielsweise auf der Oberfläche einer Kugel 2 angeordnet sein, deren Mitte im Ursprung 0 des dargestellten kartesischen Koordinatensystems x, y, z liegt, wobei die Achsen der Hauptspulen 1 mit der z-Achse zusammenfallen.

Weiter enthält das Spulensystem 10 vier Spulen 3a, 3b, mit denen das Gradientenmagnetfeld $G_z$ erzeugt wird. Ein erster Satz 3a wird dazu in entgegengesetztem Sinn in bezug auf die Durchflutung des zweiten Satzes 3b mit einem Strom erregt, was in der Figur mit und $\Theta$ angegeben ist. Hierbei stellt einen in dem Querschnitt der Spule 3 eintretenden Strom und $\Theta$ einen aus dem Querschnitt der Spule austretenden Strom dar.

Das Spulensystem 10 enthält weiter vier Rechteckspulen 5 (es sind nur zwei davon dargestellt) oder vier andere Spulen wie z. B. "Golay-Spulen" zum Erzeugen des Gradientenmagnetfelds $G_y$. Zum Erzeugen des Gradientenmagnetfelds $G_x$ dienen vier Spulen 7 mit gleicher Form wie die Spulen 5. Sie sind um einen Winkel von 90° um die z-Achse in bezug auf die Spulen 5 verdreht. In Fig. 1 ist weiter noch eine Spule 11 dargestellt, mit der ein hochfrequentes elektromagnetisches Feld erzeugbar und detektierbar ist.

In Fig. 2 ist eine Anordnung 15 zum Durchführen des Verfahrens nach der Erfindung dargestellt. Die Anordnung 15 enthält Spulen 1, 3, 5, 7 und 11, die an Hand der Fig. 1 bereits erläutert wurden, Stromgeneratoren 17, 19, 21 bzw. 23 zum Erregen der Spulen 1, 3, 5 bzw. 7 und einen Hf-Signalgenerator 25 zum Erregen der Spule 11. Die Anordnung 15 enthält weiter einen Hf-Signaldetektor 27, einen Demodulator 28, eine Abtastschaltung 29, Verarbeitungsmittel, wie z. B. einen Analog/Digital-Wandler 31, einen Speicher 33 und eine Rechenschaltung 35 zur Durchführung einer Fourier-Transformation, eine Steuereinheit 37 zum Steuern der Abtastzeitpunkte und weiter eine Wiedergabeanordnung 43 und zentrale Steuermittel 45, deren Funktionen und gegenseitige Zusammenhänge nachstehend näher erläutert werden.

Mit der dargestellten Anordnung 15 wird ein Verfahren zur Ermittlung der Kernmagnetisierungsverteilung in einem Teil eines Körpers 20 gemäss nachstehender Beschreibung durchgeführt. Das Verfahren bezieht sich auf häufiges Wiederholen eines Messzyklus, der an sich wieder in mehrere Schritte unterteilbar ist. Bei einem Messzyklus wird ein Teil der im Körper vorhandenen Kernspins resonant angeregt. Diese Kernspinresonanz ergibt sich durch das Einschalten des Stromgenerators 17 von der zentralen Steuereinheit 45 aus, wodurch die Spule 1 erregt wird und für eine gewünschte Anzahl von Messzyklen in diesem Zustand bleibt. Hierdurch wird ein stationäres und homogenes Magnetfeld Bo erzeugt. Weiter wird der Hochfrequenzgenerator 25 kurzzeitig eingeschaltet, so dass die Spule 11 ein hochfrequentes elektromagnetisches Feld (HF-Feld) erzeugt. Durch die angelegten magnetischen Felder können die Kernspins im Körper 20 angeregt werden, wobei die angeregte Kernmagnetisierung einen bestimmten Winkel, beispielsweise 90° (90°-HF-Impuls), mit der Richtung des homogenen Magnetfelds Bo bildet. An welcher Stelle und welche Kernspins angeregt werden, ist

u.a. von der Stärke des Feldes Bo anhängig, von einem möglicherweise anzulegenden Gradientenmagnetfeld und von der Kreisfrequenz $\omega_0$ des hochfrequenten elektromagnetischen Felds, da die Gleichung $\omega_0 = \gamma \cdot Bo$ (1) erfüllt werden muss, worin $\gamma$ das gyromagnetische Verhältnis ist (für freie Protonen, beispielsweise $H_2O$ Protonen ist diese $\gamma/2 \cdot \pi = 42. 576$ MHz/T). Nach einer Anregungszeit wird der Hochfrequenzgenerator 25 von den zentralen Steuermitteln 45 abgeschaltet. Die resonante Anregung erfolgt jeweils beim Beginn jedes Messzyklus. Für manche Ausführungsformen werden auch während des Messzyklus HF-Impulse erzeugt. Diese HF-Impulse sind dann beispielsweise eine Folge aus 180° HF-Impulsen, die periodisch erzeugt werden. In diesem Fall spricht man von "Spin-Echo". Spin-Echo ist u.a. in der Veröffentlichung von I.L. Pykett "NMR in Medicine", Scientific American, Mai 1982, beschrieben.

In einem folgenden Schritt werden Signale empfangen und abgetastet. Dabei können die Gradientenfelder benutzt werden, die die Generatoren 19 bzw. 21, 23 unter der Steuerung der zentralen Steuermittel 45 erzeugen. Die Detektierung des Resonanzsignals (mit der Bezeichnung FID-Signal) erfolgt durch das Einschalten des Hochfrequenzdetektors 27, des Demodulators 28, der Abtastschaltung 29, des Analog/Digital-Wandlers 31 und der Steuereinheit 37. Dieses FID-Signal ist dadurch entstanden, dass infolge des HF-Anregungsimpulses die Kernmagnetisierungen um die Feldrichtungen des Magnetfeldes Bo präzedieren. Diese Kernmagnetisierung induziert nunmehr in der Detektionsspule eine Induktionsspannung, deren Amplitude ein Mass für die Kernmagnetisierung ist.

Die von der Abtastschaltung 29 herrührenden analogen abgetasteten FID-Signale werden in die digitale Form (Wandler 31) umgesetzt und so in einen Speicher 33 eingeschrieben. Nach einer letzten Signalabtastung in einer Messzeit $T_M$ werden von den zentralen Steuermitteln 45 die Generatoren 19, 21 und 23, die Abtastschaltung 29, die Steuereinheit 37 und der Analog/Digital-Wandler 31 gestoppt.

Das abgetastete FID-Signal ist nach wie vor im Speicher 33 gespeichert. Danach wird ein folgender Messzyklus durchgeführt, bei dem ein dabei erzeugtes FID-Signal erzeugt, abgetastet und in den Speicher 33 eingeschrieben wird. Sind genug FID-Signale gemessen (die Anzahl der zu messenden FID-Signale ist beispielsweise von der gewünschten zu erreichenden Auflösung abhängig), so ist über eine zweidimendionale oder dreidimensionale Fourier-Transformation (von der Verwendung der Gradientenmagnetfelder abhängig, bei denen die FID-Signale erzeugt bzw. abgetastet werden) ein Bild der Kernmagnetisierungsverteilung zu ermitteln.

In Fig. 3a ist ein Beispiel eines Messzyklus nach der Erfindung dargestellt, der ebenfalls an Hand der Anordnung 15 in Fig. 2 erläutert wird. Mit der Hochfrequenzspule 11 wird nach dem Einschalten der Hauptspulen 1, die ein stationäres, homogenes Magnetfeld Bo erzeugen, ein 90°-Impuls P₁ erzeugt. Das danach auftretende Resonanzsignal F1 lässt man bei der Anwendung der Spin-Echotechnik abklingen, und nach einer Zeit $t_{v1}$ wird mit der Hochfrequenzspule 11 ein 180°-Impuls P₂ erzeugt. Während eines Teils der Zeit $t_{v1}$ werden mit Kurven G₁ und G₃ bezeichnete Gradientenfelder Gₓ und Gᵧ aus einem weiter unten an zugebenen Grund erzeugt. Nach einer Dauer $T_{v2}$, die genau so gross wie $t_{v1}$ ist, erreicht ein mit dem 180° Impuls P₂ erzeugtes Echoresonanzsignal F2 einen Spitzenwert. Die Anwendung der sog. Spin-Echotechnik (180°-Impuls P₂) verhindert das Auftreten von Phasenfehlern in den von Kernspins erzeugten Resonanzsignalen, wobei die Phasenfehler durch Inhomogenitäten im stationären Magnetfeld Bo auftreten. Das Echoresonanzsignal wird jeweils nach einem Abstintervall $t_m$ (in der Figur nicht angegeben) abgetastet, wobei mit einer Kurve G₂ und G₄ bezeichnete alternierende Gradientenfelder Gₓ und Gᵧ vorhanden sind.

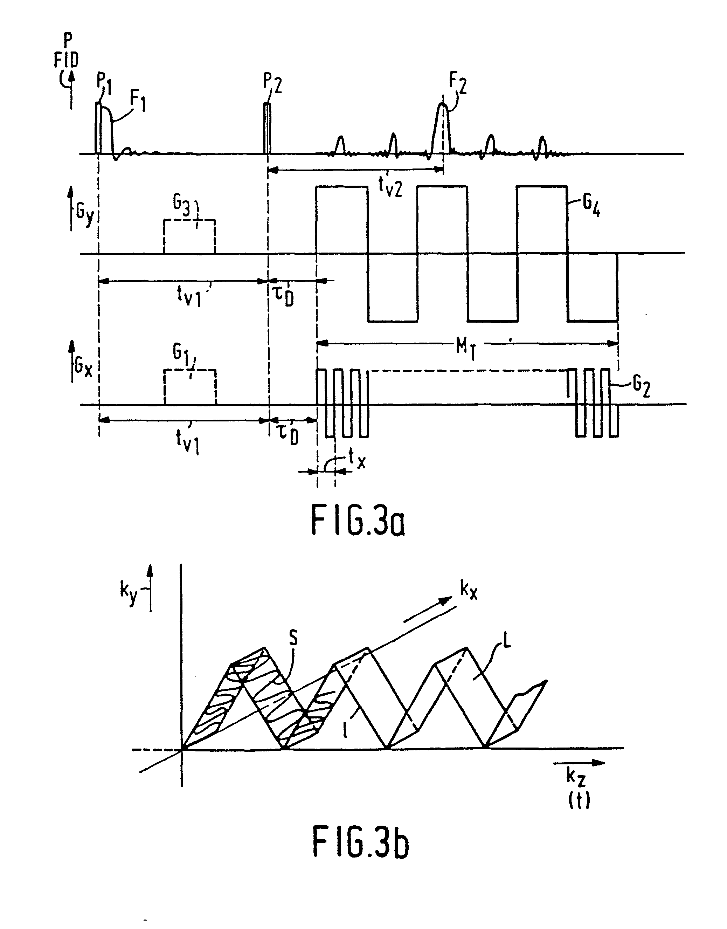

Bekanntlich ist der Phasenwinkel einer Magnetisierung an einem Punkt z in einem Gradientenmagnetfeld $G_z$ durch $\int \gamma \cdot G_z \cdot z \cdot d\tau$ bestimmt. Dabei kann eine Bildfrequenz $k_z$ mit $k_z = \gamma \cdot \int G_z \cdot d\tau$ definiert werden. Es wird also nach jeder Abstzeit $t_m$ immer eine zu einer anderen Bildfrequenz $k_z$ gehörende Signalabtastung bestimmt. Die aufeinanderfolgenden Bildfrequenzen zeigen einen Bildfrequenzunterschied $\Delta k_z = \gamma \cdot \int t_m G_z \cdot d\tau$. Es ist jetzt ersichtlich, dass, wenn ein alternierendes Gradientenfeld Gₓ angelegt wird, Signalabtastungen erhalten werden, die zu Bildfrequenzen $k_x$ gehören, die zwischen den zwei äussersten Werten $k_{xi}$ und $\gamma \cdot \int_{1/2} t_x G_2 d\tau + k_{xi}$ liegen. Hier wird das schnell alternierende Gₓ-Gradientenfeld G₂ einem langsam alternierenden Gᵧ-Gradientenfeld G₄ überlagert. Wenn dieses Gᵧ-Gradientenfeld G₄ vorhanden wäre und ein (nicht dargestelltes) konstantes Gₓ-Gradientenfeld, würden die aufeinanderfolgend durchzuführenden Signalabtastungen zu den Bildfrequenzen ($k_y$, $k_z$) gehören, wobei sich $k_y$ zwischen zwei äussersten Werten hin und her bewegt, wie in Fig. 3b mit der Linie 1 dargestellt ist. Wird nunmehr sowohl das alternierende Gᵧ-Gradientenmagnetfeld als auch das alternierende Gₓ-Gradientenfeld und ein konstantes Gz-Gradientenfeld angelegt, bildet der Weg S, auf dem sich die in der Messzeit $M_t$ durchzuführenden Signalabtastungen befinden, gleichsam eine bandförmige Fläche L bilden, die durch die Linie 1 geht und eine Breite hat, die von den zwei äussersten Werten ($k_{xi}$ und $k_{xi} + \gamma \int_{1/2} t_x \cdot G_2 \cdot d\tau$) von $k_x$ bestimmt wird. Da beim Verfahren in drei Freiheitsgraden während eines FID-Signals abgetastet wird {($k_x$, $k_y$, $k_z$ oder beispielsweise $k_x$, $k_y$, t) für Spektroskopie}, können mehrere Signalabtastungen pro FID-Signal erhalten werden, wodurch sich die Gesamtmesszeit zum Füllen einer dreidimensionalen (oder vierdimensionalen) Matrix mit Signalmustern stark verkürzt. Durch das Anlegen von Gₓ- und/oder Gᵧ-Vorbereitungsgradientenmagnetfeldern G₁ und/oder G₃ in der Vorbereitungszeit $t_{v1}$ kann die bandförmige Fläche L im ($k_x$, $k_y$, $k_z$)- oder ($k_x$, $k_y$, t)-Raum in $k_x$- und/oder $k_y$- Richtung verschoben werden, so dass eine regelmässige Ausfüllung des genannten Bildfrequenzraums oder Bildfrequenzzeitraums erhalten wird. Zum Unterdrücken von Einflüssen von T₂-Relaxationszeiten und Feldinhomogenitäten, die Geisterbilder und Vermischungseffekte bewirken, ist es vorteilhaft, die Durchführung einer Signalabtastung, die beispielsweise zur Frequenzfläche $k_z$ gehört, immer zum gleichen Zeitpunkt relativ zum Anregungsimpuls P₁ (oder Echoimpuls P₂) vorzunehmen. Dies lässt sich im dargestellten Beispiel dadurch verwirklichen, dass bei jeder anderen Voreinstellung des Gᵧ-Gradientenfeldes G₃ genaues; seines Integrals über die Zeit ein angepasster Zeitpunkt $\tau_B$ zum Einschalten der alternierenden Gₓ- und Gᵧ-Gradientenfelder G₂ und G₄ gewählt wird, wobei das G₂-Gradientenmagnetfeld und die Messzeit $M_T$ sich nicht aus ihrer Zeitlichen Lage verschieben.

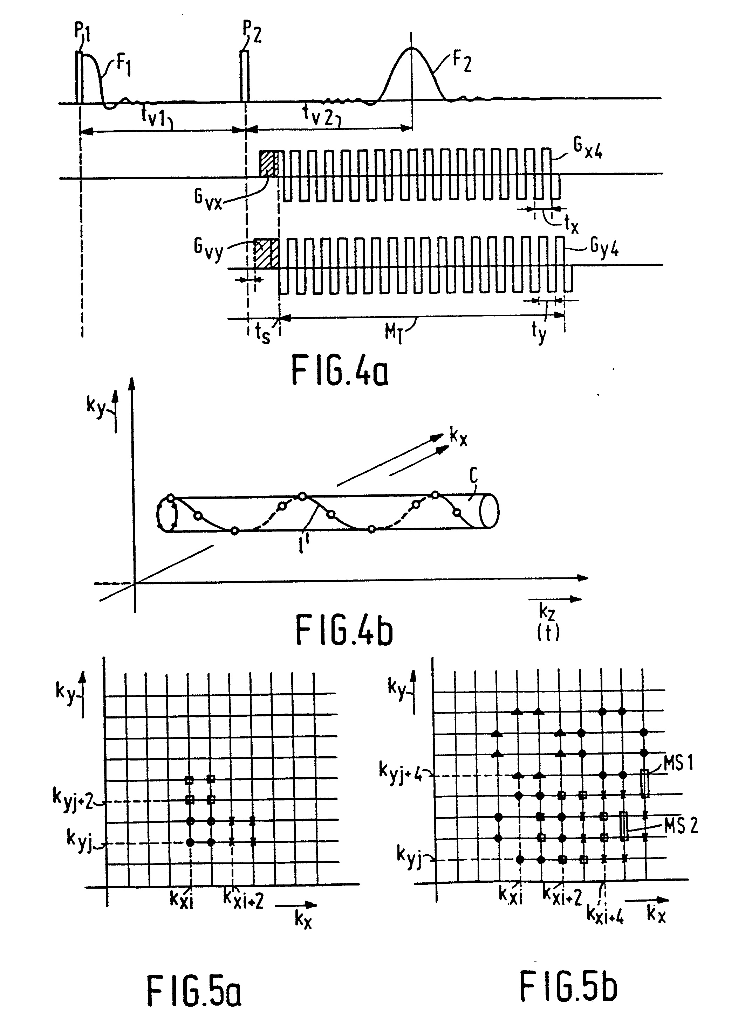

Ein bevorzugtes Ausführungsbeispiel eines erfindungsgemässen Verfahrens ist im Prinzip in Fig. 4a und 4b dargestellt. Bei diesem Verfahren weicht das angelegte Gᵧ-Gradientenmagnetfeld $G_{y4}$ von dem in Fig. 3a dargestellten Gᵧ-Gradientenfeld G₄ ab. Das Gradientenfeld $G_{y4}$ hat die gleiche Periode $t_y$, $t_x$ wie das Gradientenfeld $G_{x4}$. Die Gradientenfelder $G_{x4}$ und $G_{y4}$ haben einen Phasenunterschied vorzugsweise von 90°. Es lässt sich ableiten, dass bei zwei auf derartige Weise angelegten alternierenden Gradientenfeldern die Bildfrequenzen, bei denen Signalabtastungen durchgeführt werden, auf einer Ellipse liegen auf einem Kreis, wenn die Amplituden $G_{x4}$ und $G_{y4}$ gleich gross sind) in der $k_x$-$k_y$-Bildfrequenzfläche. Wird jetzt gleichzeitig mit den alternierenden Gradientenfeldern $G_{x4}$ und $G_{y4}$ ein konstantes Gradientenfeld Gz eingeschaltet (nur in der Messzeit $M_T$), so gehören die durchgeführten Signalabtastungen zu Bildfrequenztripeln ($k_x$, $k_y$, $k_z$), die auf einer Spirale 1' liegen, die mit einer konstante Steigung um den elliptischen (kreisförmigen Zylinder, wenn $G_{x4} = G_{y4}$) Zylinder C gewickelt ist. Durch die mögliche Verschiebung der Phasen des Gₓ- und Gᵧ-Gradientenfelds $G_{x4}$ und $G_{y4}$ in bezug auf den Anfangszeitpunkt $t_s$ der Messzeit $M_T$ kann die Spirale um die Zylinder gedreht werden (um nötigenfalls eine gleichmässigere Belegung der Zylinderoberfläche zu verwirklichen). Der Zylinder C an sich ist in der $k_x$- und/oder $k_y$-Richtung dadurch verschiebbar, dass die vorbereitenden Gradientenfelder $G_{vx}$ und/oder $G_{vy}$ (die schraffierten Flächen) in Amplitude und/oder Zeit geändert werden, so dass der ($k_x$, $k_y$, $k_z$)-Raum oder der ($k_x$, $k_y$ t)-Raum gleichmässiger belegbar sind (hierbei liegt der Anfangszeitpunkt $t_s$ in bezug auf den Impuls P₁ (oder P₂) beim Anfang jeder Messzeit zeitlich fest).

In Fig. 5a ist eine senkrechte Projektion auf die $k_x$-$k_y$-Fläche aller Messpunkte dargestellt, die längs dreier Spiralen erhalten sind. Werden je Umdrehung der Spirale vier Signalabtastungen durchgeführt, ist eine regelmässige Ausfüllung

auf kartesischen Koordinaten $k_x$, $k_y$ möglich, wie sich aus der Fig. 5a ergibt. Wird die Amplitude der Gradientenfelder $G_{x4}$ und $G_{y4}$ vergrössert und die Frequenz verringert, können mit weniger Energie bei einer niedrigeren dG/dt in der gleichen Zeit genau so viel Signalabtastungen durchgeführt werden, wobei immer noch eine "karthesische" Ausfüllung in der $k_x$ und der $k_y$ Richtung verwirklichbar ist. Statt vier werden je Umdrehung der Spirale 1' (siehe Fig. 4b) acht Signalabtastungen durchgeführt (das Abtasten ist jedoch jetzt zeitlich nicht mehr äquidistant), die auf acht Ecken liegen, die in Fig. 5b mit O, ☐, x, Δ und · dargestellt sind. Durch die Überlappung der "Zylinder" wird eine "kartesische" Ausfüllung der $k_x$-$k_y$-Fläche verwirklicht (siehe Beispiel ☐ O x). Est ist nur in der $k_z$-Richtung eine Phasenkorrektur erforderlich, die für sieben auf einer Spirale aufeinanderfolgende Signalabtastungen verschieden ist (angenommen sei, dass eine der acht "gut" auf dem $k_z$-Gitter liegt), was auch für drei der vier Signalabtastungen gilt, die nach Fig. 5a gemessen sind. Die durchzuführende Phasenkorrektur ist an sich schon aus der niederländischen Patentanmeldung NL-A 8 203 519 bekannt. Weiter ist es erforderlich, die in den am Rand des auszufüllenden $k_x$-$k_y$-Raums auftretenden Löchern MS1 und MS2 fehlenden Signalabtastungen nachzufüllen. Da es hier immer um zwei benachbarte Signalabtastungen handelt ($k_x$ = konstant), sind mit dem in der bereits erwähnten niederländischen Patentanmeldung NL-A 8 203 519 beschriebenen Verfahren ($G_z$ = konstant, $G_y$ = moduliert) die erwähnten Löcher MS1 und MS2 nacheinander ausfüllbar.

Die vorangehenden und anhand der Fig. 4a, b und 5a, b beschriebenen Verfahren eignen sich ebenfalls besonders zum Betreiben von bildformender NMR-Spektroskopie, und hierzu muss beispielsweise in der Messzeit $M_T$ kein Gradientenfeld angelegt werden, sondern muss in der Vorbereitungszeit (beispielsweise während $t_{v1}$ oder nach $P_2$ und vor $t_s$) eine Voreinstellung $k_z$ mit einem Gradientenfeld $G_z$ durchgeführt werden.

Zum Wählen/Einstellen einer bestimmten Impulsfolge, von Zeitintervallen und zugeordneten Gradientenmagnetfeldern für einen Messzyklus werden vorprogrammierte Computermittel benutzt. In einer Ausführungsform der Anordnung 15 (Fig. 2) enthalten die zentralen Steuermittel 45 einen vorprogrammierten Rechner (VAX 11/730) mit einer Eingabe- und Ausgabe-Station 52 für Steuerdaten und einer Schnittstelle 53 (siehe Fig. 5). Ausgänge 55 der Schnittstelle 53 sind über den Bus 50 (siehe Fig. 2) mit den zu steuernden Stromgeneratoren 19, 21, 23 und 25 sowie mit den Steuereingängen des Empfängers 27, des Demodualtors 28 und der Abtastschaltung 29 verbunden.

## Patentansprüche

1. Verfahren zum Ermitteln einer Kernspinmagnetisietungsverteilung in einem Teil eines Körpers, bei dem ein stationäres homogenes Magnetfeld erzeugt wird, in dem sich der Teil des Körpers befindet, und

a) ein hochfrequenter elektromagnetischer Impuls zum Auslösen einer präzedierenden Bewegung der Magnetisierung der Kerne im Körper erzeugt wird, wobei sich ein Resonanzsignal ergibt,
b) wobei nach einer Vorbereitungszeit während einer oder mehrerer Messzeiten ein alternierendes, periodisches Gradientenmagnetfeld erzeugt wird, wobei die Messzeit(en) in eine Anzahl von Abtastintervallen zum Durchführen einer Anzahl von Signalabtastungen des Resonanzsignals aufgeteilt ist (sind),
c) wonach jeweils nach einer Wartezeit die Schritte a) und b) einige Male wiederholt werden, wobei die Dauer der Vorbereitungszeit und/oder das Integral zumindest eines in der Vorbereitungszeit angelegten Gradientenmagnetfelds über die Vorbereitungszeit jeweils einen verschiedenen Wert hat zum Erhalten einer Gruppe von Signalabtastungen, aus der nach einer Signaltransformation ein Bild einer Kernmagnetisierung bestimmt wird,

*dadurch gekennzeichnet*, dass in der Messzeit ein zweites periodisches alternierendes Gradientenmagnetfeld angelegt wird, dessen Gradientenrichtung senkrecht zur Gradientenrichtung des erstgenannten alternierenden Gradientenmagnetfelds verläuft.

2. Verfahren nach Anspruch 1, *dadurch gekennzeichnet*, dass die zwei periodischen alternierenden Gradientenmagnetfelder ($G_{x4}$, $G_{y4}$) die gleiche Periode haben und in der Phase gegeneinander verschoben sind.

3. Verfahren nach Anspruch 1 oder 2, *dadurch gekennzeichnet*, dass die beiden alternierenden Gradientenmagnetfelder um 90° phasenverschoben sind.

4. Verfahren nach Anspruch 1, 2 oder 3, *dadurch gekennzeichnet*, dass pro Periode eines alternierenden Gradientenmagnetfelds zumindest viermal eine Signalabtastung durchgeführt wird.

5. Verfahren nach Anspruch 1, 2, 3 oder 4, *dadurch gekennzeichnet*, dass der Anfangszeitpunkt eines der alternierenden Gradientenmagnetfelder mit dem Ende der Vorbereitungszeit zusammenfällt und dass die erste Signalabtastung immer nach dem gleichen Zeitintervall nach dem hochfrequenten elektromagnetischen Impuls anfängt.

6. Verfahren nach Anspruch 1, 2, 3 oder 4, *dadurch gekennzeichnet*, dass in einander auffol-

11

genden Messzyklen die Stärken dar alternierenden Gradientenmagnetfelder die gleichen Werte haben.

7. Verfahren nach einem oder mehreren der vorangehenden Ansprüche, *dadurch gekennzeichnet,* dass in der Vorbereitungszeit zumindest zwei Vorbereitungsgradientenmagnetfelder angelegt werden, wobei das Integral über die Zeit zumindest eines Vorbereitungsgradientenmagnetfelds in zwei einander auffolgenden Messzyklen einen verschiedenen Wert hat.

8. Verfahren nach einem der vorangehenden Ansprüche, *dadurch gekennzeichnet,* dass je Periode eines alternierenden Gradientenmagnetfelds acht Signalabtastungen durchgeführt werden.

9. Verfahren nach Anspruch 8, *dadurch gekennzeichnet,* dass von den zwei Vorbereitungsgradienten-magnetfeldern die jeweiligen Gradientenrichtungen gleich den jeweiligen Gradientenrichtungen der zwei alternierenden Gradientenmagnetfelder sind.

10. Verfahren nach einem oder mehreren der vorangehenden Ansprüche 1 bis 5 oder 7 bis 9, *dadurch gekennzeichnet,* dass in einander auffolgenden Messzyklen alternierende Gradientenmagnetfelder verwendet werden, deren Periodedauer verschieden ist und das Verhältnis zwischen der maximalen Feldstärke des gesamten erzeugten alternierenden Gradientenmagnetfelds und der Periodendauer immer kleiner oder gleich einem vorgegebenen festen Wert ist.

11. Anordnung zur Ermittlung einer Kernmagnetisierungsverteilung in einem Teil eines Körpers, wobei die Anordnung folgendes enthält,

a) Mittel zum Erzeugen eines stationären, homogenen Magnetfelds,
b) Mittel zum Erzeugen hochfrequenter elektromagnetischer Strahlung,
c) Mittel zum Erzeugen eines konstanten Gradientenmagnetfelds,
d) Mittel zum Erzeugen eines alternierenden periodischen Gradientenmagnetfelds,
e) Abtastmittel zur Durchführung von Signalabtastungen eines mit den unter a) und b) erwähnten Mitteln erzeugten Resonanzsignals bei einem mit den unter d) erwähnten Mitteln erzeugten alternierenden Gradientenmagnetfeld,
f) Verarbeitungsmittel zum Verarbeiten der Signalabtastungen zu einer Kernmagnetisierungsverteilung, und
g) Steuermittel zum Steuern zumindest der unter b) bis f) erwähnten Mittel zum Erzeugen, Konditionieren, Abtasten einer Anzahl von Resonanzsignalen und zum Verarbeiten der Signalabtastungen,

*dadurch gekennzeichnet,* dass die Anordnung Mittel zum Erzeugen von zwei alternierenden

12

Gradientenmagnetfeldern enthält, deren Gradientenrichtungen senkrecht zueinander verlaufen.

12. Anordnung nach Anspruch 11, *dadurch gekennzeichnet,* dass die Perioden der alternierenden Gradientenmagnetfelder gleich und über 90° phasenverschoben sind.

13. Anordnung nach Anspruch 11 oder 12, *dadurch gekennzeichnet,* dass die Periode der alternierenden Gradientenfelder einstellbar ist.

14. Anordnung nach Anspruch 13, *dadurch gekennzeichnet,* dass die Stärke der alternierenden Gradientenmagnetfelder einstellbar ist.

**Claims**

1. A method of determining a nuclear-magnetization, distribution in a region of a body which is situated in a generated steady, uniform magnetic field, and

a) an r.f.electromagnetic pulse is generated in order to cause a precessional motion of the magnetization of the nuclei in the body, resulting in a resonance signal,
b) after a preparation period, a steady gradient magnetic field and an alternating, periodic gradient magnetic field are generated during one or more measurement periods, said measurement period (periods) being divided into a number of sampling intervals for taking a number of signal samples of the resonance signal,
c) each time after a waiting period, the steps a) and b) are repeated a number of times, the duration of the preparation period and/or the integral over the preparation period of at least one gradient magnetic field applied during the preparation period each time having a different value in order to obtain a group of signal samples from which, after a signal transformation, an image of a nuclear magnetization is determined,

*characterized in that* during the measurement period there is applied a second periodic alternating gradient magnetic field whose gradient direction extends perpendicularly to the gradient direction of the first-mentioned alternating gradient magnetic field.

2. A method as claimed in Claim 1, *characterized in that* the two periodic, alternating gradient magnetic fields ($G_{x4}$, $G_{y4}$) have the same period and have been phase-shifted with respect to one another.

3. A method as claimed in Claim 1 or 2, *characterized in that* the two alternating gradient magnetic fields have been phase-shifted 90°.

7

4. A method as claimed in Claim 1, 2 or 3, *characterized in that* per period of an alternating gradient magnetic field a signal sample is taken at least four times.

5. A method as claimed in Claim 1, 2, 3 or 4, *characterized in that* the starting instant of one of the alternating gradient magnetic fields coincides with the end of the preparation period, the instant at which a first signal sample is taken always commencing the same time interval after the r.f. electromagnetic pulse.

6. A method as claimed in Claim 1, 2, 3 or 4, *characterized in that* during successive measurement cycles the strengths of the alternating gradient magnetic fields have the same values.

7. A method as claimed in one or more of the preceding Claims, *characterized in that* during the preparation period there are applied at least two preparation gradient magnetic fields, the integral over the period of at least one preparation gradient magnetic field having a different value in two successive measurement cycles.

8. A method as claimed in any one of the preceding Claims, *characterized in that* eight signal samples are taken per period of an alternating gradient magnetic field.

9. A method as claimed in Claim 8, *characterized in that* the receptive gradient directions of the two preparation gradient magnetic fields are the same as the respective gradient directions of the two alternating gradient magnetic fields.

10. A method as claimed in one or more of the preceding Claims 1 to 5 or 7 to 9, *characterized in that* alternating gradient magnetic fields are applied during successive measurement cycles, the periods of said fields being different and the ratio of the maximum field strength of the total generated alternating gradient magnetic field to the period always being smaller than or equal to a predetermined, fixed value.

11. A device for determining a nuclear-magnetization distribution in a region of a body, comprising

a) means for generating a steady, uniform magnetic field,
b) means for generating r.f. electromagnetic radiation,
c) means for generating a steady, gradient magnetic field,
d) means for generating an alternating, periodic gradient magnetic field,
e) sampling means for taking signal samples of a resonance signal generated by the means specified sub a) and b) in the presence of an alternating gradient magnetic field generated by the means specified sub d),

f) processing means for the processing of the signal samples in order to obtain a nuclear-magnetization distribution, and

g) control means for controlling at least the means specified sub b) or f) for generating, conditioning, and sampling a number of resonance signals and for processing the signal samples,

*characterized in that* the device comprises means for generating two alternating gradient magnetic fields whose gradient directions are mutually perpendicular.

12. A device as claimed in Claim 11, *characterized in that* the periods of the alternating gradient magnetic fields are the same and phase-shifted through 90°.

13. A device as claimed in Claim 11 or 12, *characterized in that* the period of the alternating gradient magnetic fields is adjustable.

14. A device as claimed in Claim 13, *characterized in that* the strength of the alternating gradient magnetic fields is adjustable.

**Revendications**

1. Procédé pour déterminer une distribution de la magnétisation nucléaire dans une région d'un corps, suivant lequel un champ magnétique homogène stationnaire, dans lequel se trouve la région du corps, est engendré, et

a) une impulsion électromagnétique de haute fréquence est engendrée pour déclencher un mouvement de précession de la magnétisation des noyaux dans le corps, de sorte qu'un signal de résonance apparaît;
b) après un temps de séparation pendant un ou plusieurs temps de mesure, un champ magnétique de gradient stationnaire et un champ magnétique de gradient périodique alternant sont engendrés, le ou les temps de mesure étant divisés en un certain nombre d'intervalles d'échantillonnage pour l'exécution d'un certain nombre d'échantillonnages du signal de résonance;
c) chaque fois après un temps d'attente, les stades a) et b) sont répétés quelques fois, la durée du temps de préparation et/ou l'intégrale d'au moins un champ magnétique de gradient entretenu pendant le temps de préparation a chaque fois une valeur différente sur le temps de préparation, pour obtenir un groupe d'échantillons de signaux à partir duquel, après une transformation de signaux, une image

de la magnétisation nucléaire est déterminée, caractérisé en ce qu'un second champ magnétique de gradient périodique alternant, dont la direction de gradient est perpendiculaire à la direction de gradient du champ magnétique de gradient alternant cité en premier lieu, est entretenu pendant le temps de mesure.

2. Procédé suivant la revendication 1, caractérisé en ce que les deux champs magnétiques de gradient périodiques alternants ($G_{x4}$, $G_{y4}$) ont la même période et sont décalés en phase l'un par rapport à l'autre.

3. Procédé suivant la revendication 1 ou 2, caractérisé en ce que les deux champs magnétiques de gradient alternants sont décalés de 90° en phase.

4. Procédé suivant la revendication 1, 2 ou 3, caractérisé en ce qu'un échantillonnage de signal est exécuté au moins quatre fois par période d'un champ magnétique de gradient alternant.

5. Procédé suivant la revendication 1, 2, 3 ou 4, caractérisé en ce que le moment initial de l'un des champs magnétiques de gradient alternants coïncide avec la fin du temps de préparation et que le premier échantillonnage de signal commence toujours après le même intervalle de temps après l'impulsion électromagnétique de haute fréquence.

6. Procédé suivant la revendication 1, 2, 3 ou 4, caractérisé en ce que les intensités des champs magnétiques de gradient alternants ont les mêmes valeurs dans les cycles de mesure successifs.

7. Procédé suivant une ou plusieurs des revendications précédentes, caractérisé en ce qu'au moins deux champs magnétiques de gradient de préparation sont entretenus pendant le temps de préparation, l'intégrale dans le temps d'au moins un champ magnétique de gradient de préparation ayant une valeur différente dans deux cycles de mesure successifs.

8. Procédé suivant l'une quelconque des revendications précédentes, caractérisé en ce que huit échantillonnages de signaux sont exécutés par période d'un champ magnétique de gradient alternant.

9. Procédé suivant la revendication 8, caractérisé en ce que les directions de gradient de chacun des deux champs magnétiques de gradient de préparation sont égales aux directions de gradient de chacun des deux champs magnétiques de gradient alternants.

10. Procédé suivant une ou plusieurs des revendications 1 à 5 ou 7 à 9, caractérisé en ce qu'on utilise, dans des cycles de mesure successifs, des champs magnétiques de gradient alternants dont la période est différente et le rapport entre l'intensité de champ maximale du champ magnétique de gradient alternant engendré total et la période est toujours inférieur ou égal à une valeur fixe donnée.

11. Dispositif pour déterminer une distribution de la magnétisation nucléaire dans une partie d'un corps, le dispositif comprenant ce qui suit

a) des moyens pour engendrer un champ magnétique homogène stationnaire;
b) des moyens pour engendrer un rayonnement électromagnétique de haute fréquence;
c) des moyens pour engendrer un champ magnétique de gradient constant;
d) des moyens pour engendrer un champ magnétique de gradient périodique alternant;
e) des moyens d'échantillonnage pour l'exécution d'échantillonnages d'un signal de résonance engendré à l'aide des moyens cités sous a) et b) pendant le champ magnétique de gradient stationnaire et le champ magnétique de gradient alternant engendrés à l'aide des moyens cités sous c) et d);
f) des moyens de traitement pour transformer les échantillons de signaux en une distribution de la magnétisation nucléaire, et
g) des moyens de commande pour commander au moins les moyens cités sous b) à f) pour engendrer, conditionner et échantillonner un certain nombre de signaux de résonance et pour transformer les échantillons de signaux,

caractérisé en ce que le dispositif comprend des moyens pour engendrer deux champs magnétiques de gradient alternants dont les directions de gradient sont mutuellement perpendiculaires.

12. Dispositif suivant la revendication 11, caractérisé en ce que les périodes des champs magnétiques de gradient alternants sont égales et sont décalées de 90° en phase.

13. Dispositif suivant la revendication 11 ou 12, caractérisé en ce que la période des champs magnétiques de gradient alternants est réglable.

14. Dispositif suivant la revendication 13, caractérisé en ce que l'intensité des champs magnétiques de gradient alternants est réglable.

FIG.1

FIG.2

FIG.6

FIG.3a

FIG.3b

FIG.4a

FIG.4b

FIG.5a

FIG.5b

5